# EUROPEAN PATENT APPLICATION

(11) **EP 3 482 861 A1**
(43) Date of publication of application: **15.05.2019**
(21) Application number: 18165646.3
(22) Date of filing: 04.04.2018
(51) Int. Cl.: B23K 1/00, B23K 1/008, B23K 3/04, H05K 3/34, B65G 17/06, B23K 101/42

(54) **VACUUM REFLOW OVEN**

(30) Priority: 14.11.2017 TW 106139232
(71) Applicant: 3S Silicon Tech, Inc., Sinfong Township, Hsinchu County (TW)
(72) Inventor: WU, Chuan-Jen, Sinfong Township, Hsinchu County (TW); PENG, Jung-Kuei, Sinfong Township, Hsinchu County (TW); HUANG, Cheng-Shang, Sinfong Township, Hsinchu County (TW); WU, Mao-Jung, Sinfong Township, Hsinchu County (TW)
(74) Representative: Viering, Jentschura & Partner mbB Patent- und Rechtsanwälte

(57) **Abstract**

A vacuum reflow oven has a processing apparatus (10), and a vacuum generating device and at least one conveying device (30) disposed on the processing apparatus (10). The at least one conveying device (30) moves multiple lead frames from an input end (111) to an output end (112) of a conveying platform (11). When each lead frame is moved to correspond in position to the vacuum generating device, the vacuum generating device encloses the lead frame in a vacuum chamber to force gas inside melted solder paste on the lead frame to dissipate. Thus, voids inside the solder paste can be eliminated. Accordingly, joint strength of the solder paste can be enhanced, electrical resistance of a solder layer that is formed from the solder paste can be lowered, and quality of a soldering process is stable.

## Description

### 1. Field of the Invention

The present invention relates to a reflow oven, especially to a vacuum reflow oven that is able to form a vacuum chamber therein.

### 2. Description of the Prior Art(s)

Surface-mount technology (SMT) is a method for soldering and attaching a chip onto a copper lead frame with solder paste. Steps of performing the SMT includes: printing the solder paste onto predetermined positions of a lead frame; placing the chips at the solder paste on the predetermined positions; sending the lead frame into a reflow oven to heat the lead frame; and cooling the solder paste. When the solder paste is heated and melted in the reflow oven, the melted solder paste bonds with leads of chips. As the solder paste is cooled to become solid, the chips are electrically connected to circuits on the lead frame.

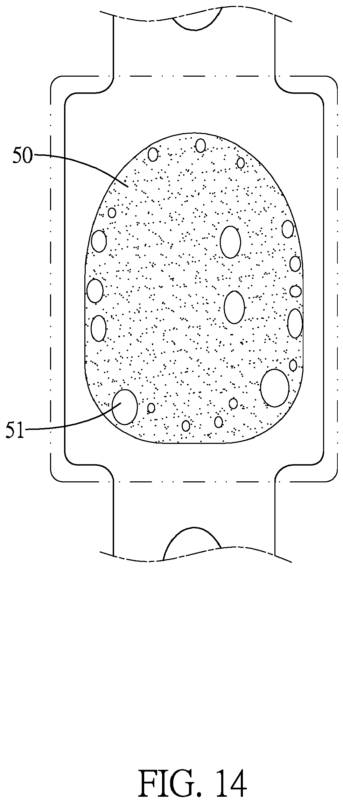

However, with reference to Fig. 14, in the process of heating and melting the solder paste 50, solvent in solder flux of the solder paste 50 would be volatilized to become gas. If the gas does not dissipate from the melted solder paste 50 before the solder paste 50 is cooled and solidified, the gas forms voids 51 inside the solidified solder paste 50. Consequently, joint strength between the solder paste 50 and the leads of the chips is reduced, electrical resistance of a solder layer that is formed from the solder paste 50 is high, and quality of a soldering process is unstable.

The main objective of the present invention is to provide a vacuum reflow oven. The vacuum reflow oven has a processing apparatus, a vacuum generating device, and at least one conveying device.

The processing apparatus has a conveying platform and a cover selectively covering on the conveying platform. The conveying platform has multiple heating bases arranged between an input end and an output end of the conveying platform.

The vacuum generating device is mounted on the processing apparatus and includes a lower seat mounted on the conveying platform, an outer cap mounted on the cover, an inner cap disposed in the outer cap, and a driving mechanism selectively driving the inner cap to move upward and downward. One of the heating bases is mounted in the lower seat. When the inner cap is driven to cover on the lower seat, a vacuum chamber is defined between the inner cap and the lower seat.

The at least one conveying device is disposed on the conveying platform and has four supporting rods separately mounted on the heating bases, a Z-axis driving assembly, and an X-axis driving assembly. The Z-axis driving assembly is connected to the four supporting rods and selectively drives the four supporting rods to move upward and downward perpendicular to the conveying platform. The X-axis driving assembly is connected to the four supporting rods and selectively drives the four supporting rods to move back and forth between the input end and the output end of the conveying platform.

The at least one conveying device moves multiple lead frames from the input end to the output end of the conveying platform. When each one of the lead frames is moved to be placed on the lower seat of the vacuum generating device, the vacuum generating device encloses the lead frame in the vacuum chamber to force gas inside melted solder paste on the lead frame to dissipate from the solder paste. Thus, voids inside the solder paste can be eliminated. Accordingly, joint strength of the solder paste can be enhanced, electrical resistance of a solder layer that is formed from the solder paste can be lowered, and quality of a soldering process is stable.

### IN THE DRAWINGS:

Fig. 1 is a perspective view of a vacuum reflow oven in accordance with the present invention;
Fig. 2 is an end view of the vacuum reflow oven in Fig. 1, showing that a cover covers on a conveying platform;
Fig. 3 is an end view of the vacuum reflow oven in Fig. 1, showing that the cover is opened relative to the conveying platform;
Fig. 4 is an enlarged cross-sectional perspective view of the conveying platform of the vacuum reflow oven in Fig. 1;
Fig. 5 is an enlarged cross-sectional side view of the conveying platform of the vacuum reflow oven in Fig. 1;
Fig. 6 is an exploded perspective view of a vacuum generating device of the vacuum reflow oven in Fig. 1;
Fig. 7 is an enlarged cross-sectional perspective view of a processing apparatus of the vacuum reflow oven in Fig. 1, showing that an inner cap is opened relative to a lower seat;
Fig. 8 is an enlarged cross-sectional perspective view of a processing apparatus of the vacuum reflow oven in Fig. 1, showing that the inner cap covers on the lower seat;
Fig. 9 is a perspective view of a conveying device of the vacuum reflow oven in Fig. 1;
Figs. 10 to 12 are operational side views of the conveying device of the vacuum reflow oven in Fig. 1;
Fig. 13 is a schematic top view of solder paste without voids; and
Fig. 14 is a schematic top view of solder paste with voids.

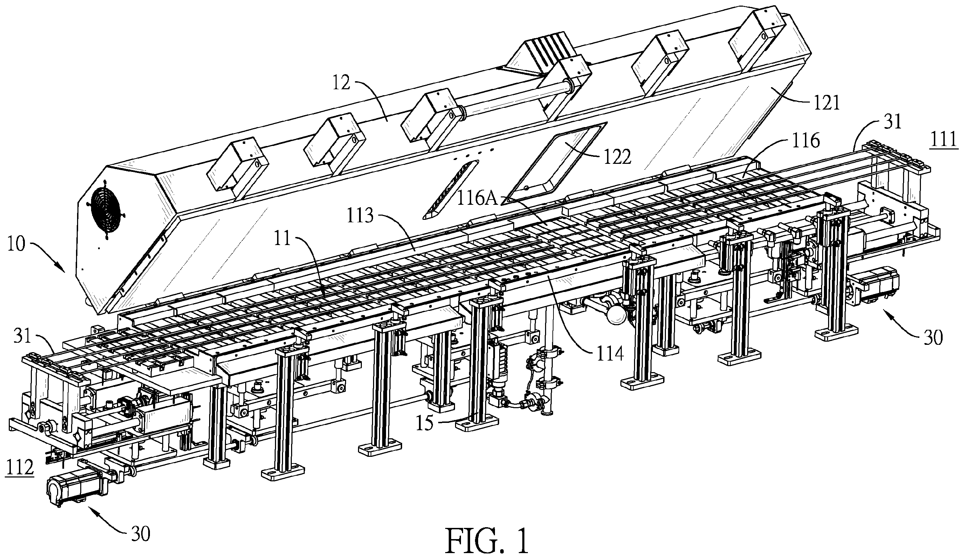

With reference to Figs. 1 to 3, a vacuum reflow oven in accordance with the present invention comprises a processing apparatus 10, a vacuum generating device 20, and at least one conveying device 30.

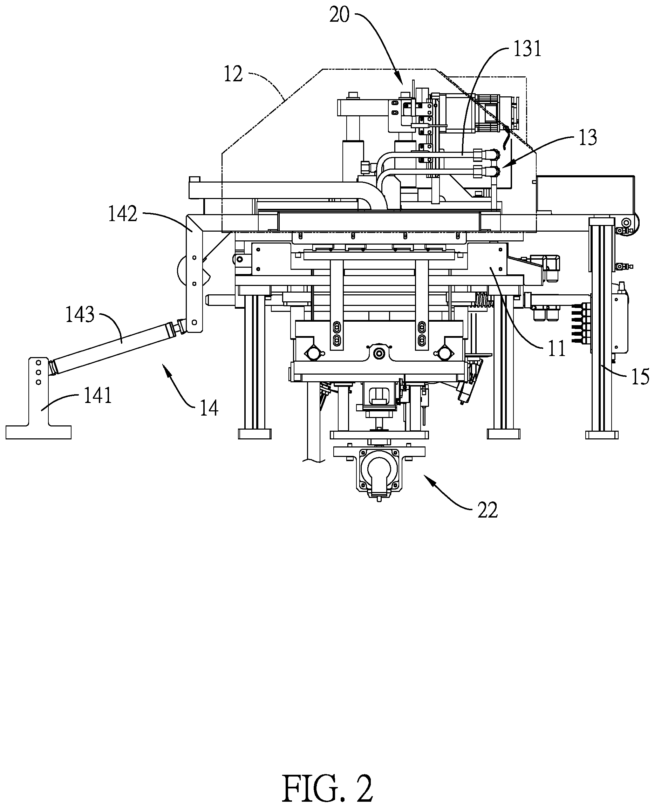

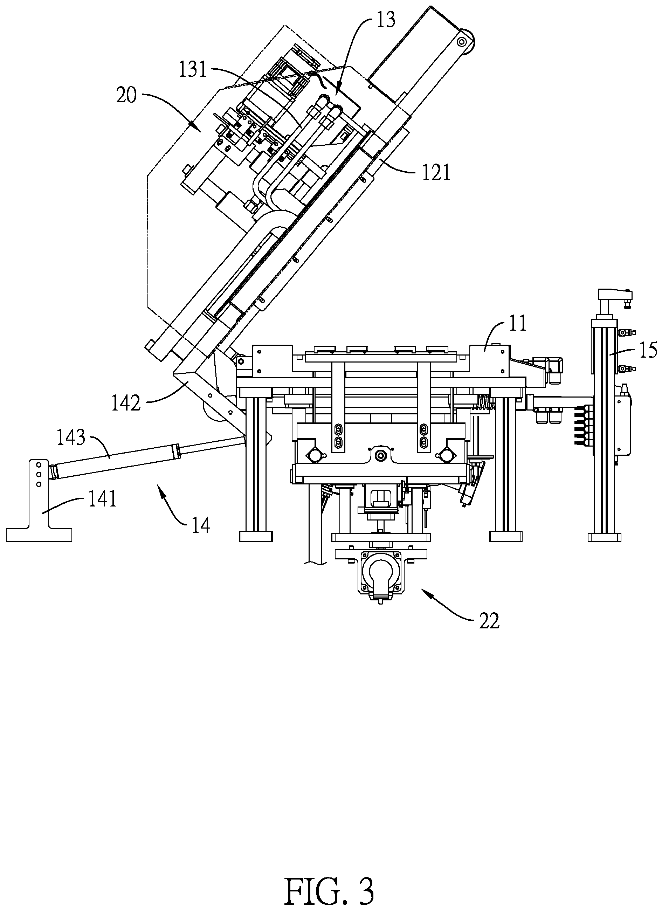

As shown in Figs. 2 and 3, the processing apparatus 10 includes a conveying platform 11, a cover 12, and a nitrogen supply device 13.

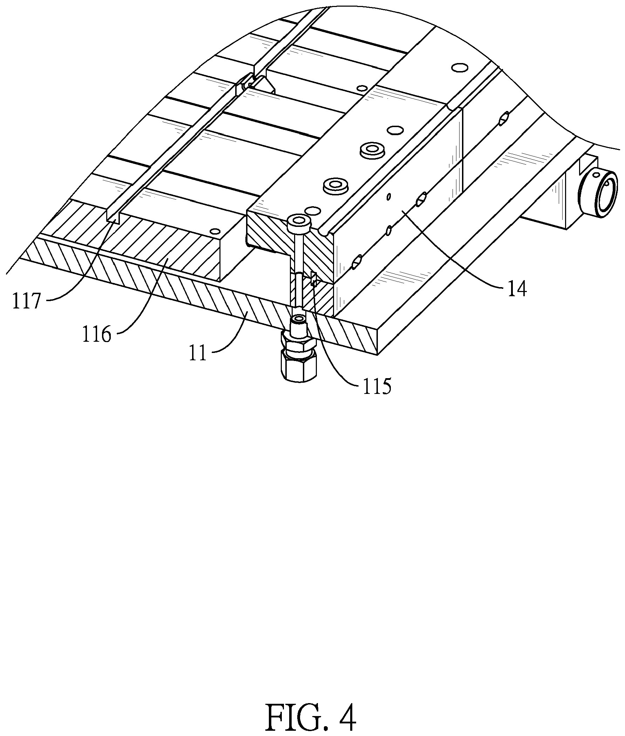

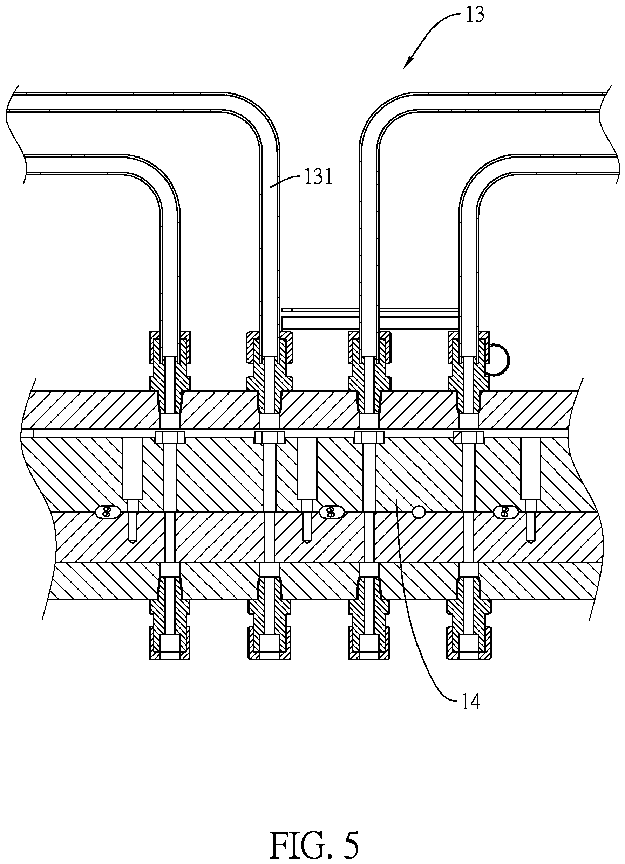

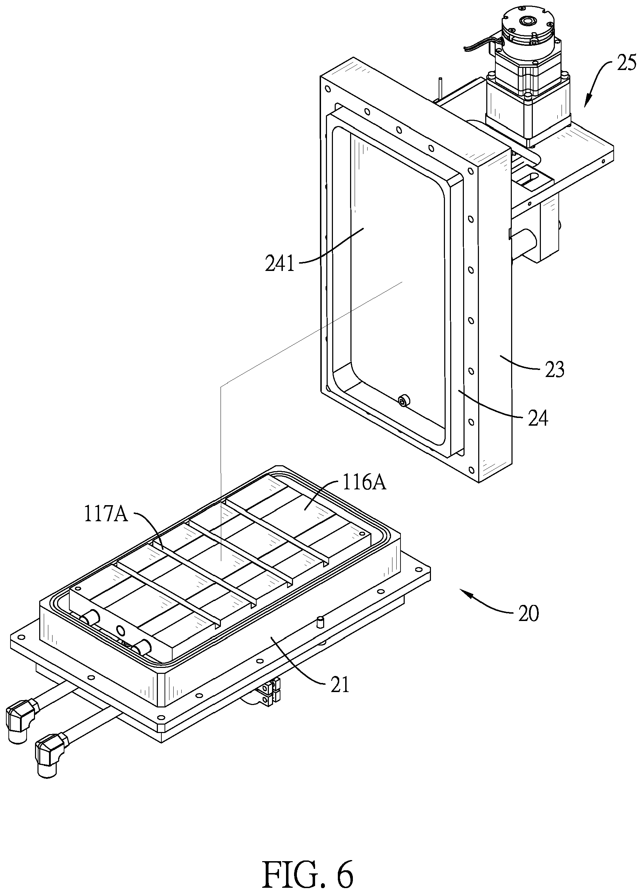

With reference to Figs. 4 to 6, the conveying platform 11 has an input end 111, an output end 112, a first side portion 113, a second side portion 114, multiple heating bases 116, 116A, and a gas channel 115. The input end 111 and the output end 112 are oppositely defined on the conveying platform 11. The first side portion 113 and the second side portion 114 are defined between the input end 111 and the output end 112 and are oppositely defined on the conveying platform 11. The heating bases 116, 116A are arranged between the input end 111 and the output end 112. Each of the heating base 116, 116A has an upper surface and four grooves 117, 117A. The four grooves 117, 117A are separately formed in the upper surface of the heating base 116, 116A and are parallel with each other. Each of the grooves 117, 117A extends toward the input end 111 and the output end 112 of the conveying platform 11. Each of the heating bases 116, 116A is used for supporting and heating a lead frame. The gas channel 115 is formed in the second side portion 14, extends toward the input end 111 and the output end 112 of the conveying platform 11, and communicates with a space defined between the first side portion 113 and the second side portion 114.

The cover 12 selectively covers on the conveying platform 11 and has a bottom panel 121 and a through hole 122. The bottom panel 121 faces the conveying platform 11. The through hole 122 is formed through the bottom panel 121 and corresponds in position to one of the heating bases 116, 116A when the cover 12 covers on the conveying platform 11.

The nitrogen supply device 13 is connected with the gas channel 115 of the conveying platform 11 through a nitrogen pipeline 131 and fills the gas channel 115 and the space defined between the first side portion 113 and the second side portion 114 of the conveying platform 11 with nitrogen. In the preferred embodiment, the nitrogen supply device 13 is mounted on the cover 12. When the cover 12 covers on the conveying platform 11, the nitrogen pipeline 131 of the nitrogen supply device 13 is connected with the gas channel 115 in the second side portion 114 of the conveying platform 11.

As shown in Figs. 1 to 3, in the preferred embodiment, the cover 12 is pivotally connected to the first side portion 113 of the conveying platform 11 and the processing apparatus 10 further has at least one opening mechanism 14 and at least one holding mechanism 15.

The at least one opening mechanism 14 is disposed beside the first side portion 113 of the conveying platform 11, is connected to the cover 12, and selectively drives the cover 12 to pivot relative to the conveying platform 11, such that the cover 12 is able to be opened relative to the conveying platform 11 or to cover on the conveying platform 11. Specifically, each of the at least one opening mechanism 14 includes a fixed seat 141, a connecting member 142, and a retractable rod 143. The fixed seat 141 is mounted beside the first side portion 113 of the conveying platform 11. The connecting member 142 is securely mounted on the cover 12 and is pivotally connected to the first side portion 113 of the conveying platform 11. The retractable rod 143 has two ends respectively connected to the fixed seat 141 and the connecting member 142. When a length of the retractable rod 143 is lengthened or shortened, the retractable rod 143 drives the cover 12 to open relative to the conveying platform 11 or to cover on the conveying platform 11. Specifically, the retractable rod 143 may be a cylinder, such as an air cylinder or an oil cylinder.

The at least one holding mechanism 15 is disposed beside the second side portion 114 of the conveying platform 11 and selectively presses on the cover 12 when the cover 12 covers on the conveying platform 11, so as to prevent the cover 12 from opening unexpectedly.

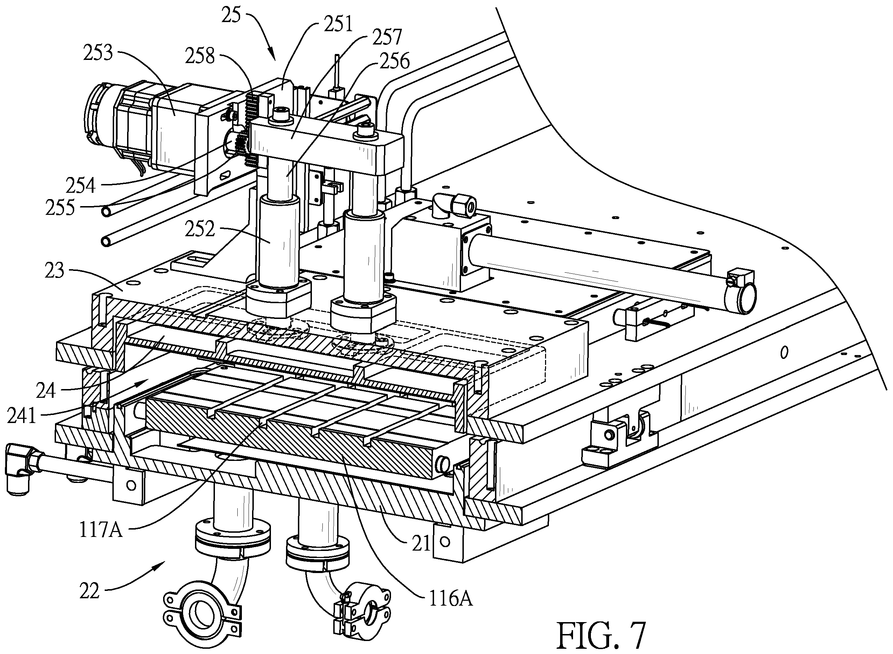

With further reference to Fig. 7, the vacuum generating device 20 is mounted on the processing apparatus 10 and corresponds in position to the through hole 122 on the bottom panel 121 of the cover 12. The vacuum generating device 20 includes a lower seat 21, an outer cap 23, an inner cap 24, and a driving mechanism 25. The lower seat 21 is mounted on the conveying platform 11 and is connected with a vacuum generating pipeline 22. The heating base 116A that corresponds in position to the through hole 122 of the bottom panel 121 is mounted in the lower seat 21. The outer cap 23 is securely mounted on the bottom panel 121 and corresponds in position to the through hole 122 of the bottom panel 121. The outer cap 23 has an opening. The opening of the outer cap 23 is defined on a bottom of the outer cap 23 and faces toward and communicates with the through hole 122 of the bottom panel 121. The inner cap 24 is disposed in the outer cap 23 and has an opening. The opening of the inner cap 24 is defined on a bottom of the inner cap 24. The driving mechanism 25 is connected to the inner cap 24 and selectively drives the inner cap 24 to move outward and inward relative to the cover 12.

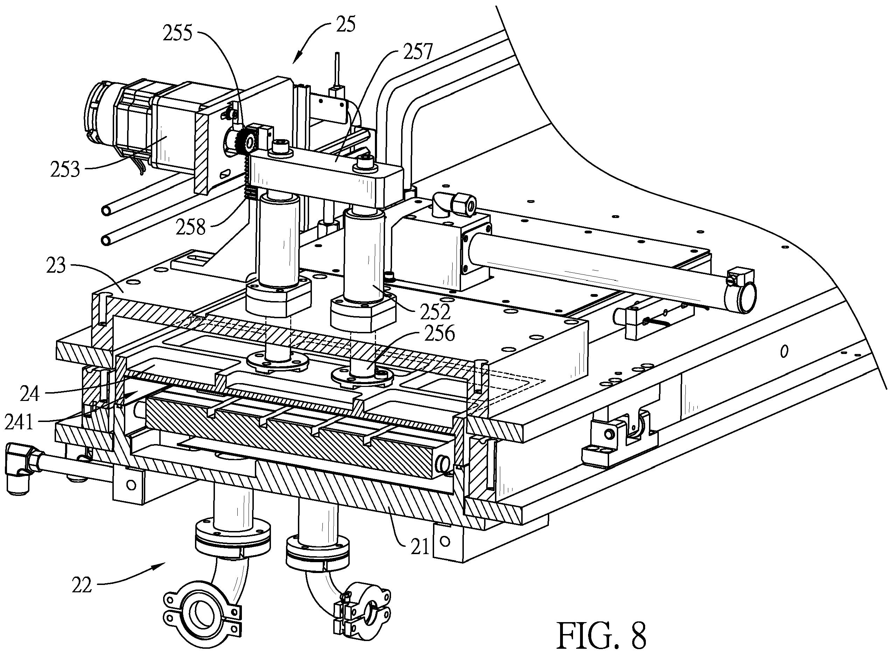

With further reference to Fig. 8, when the cover 12 covers on the conveying platform 11, the driving mechanism 25 further drives the inner cap 24 to move downward to cover on the lower seat 21. Thus, the heating base 116A and the lead frame on the heating base 116A are enclosed in a vacuum chamber 241 defined between the inner cap 24 and the lower seat 21. By drawing air from the vacuum chamber 241 through the vacuum generating pipeline 22, the vacuum chamber 241 can become a vacuum.

In the preferred embodiment, the driving mechanism 25 includes a mounting seat 251, at least one guiding tube 252, a driving motor 253, a pinion 255, at least one sliding rod 256, a moving seat 257, and a rack 258. The mounting seat 251 and the at least one guiding tube 252 are securely mounted on the outer cap 23. The driving motor 253 is securely mounted on the mounting seat 251 and has a driving rod 254. The pinion 255 is securely mounted on the driving rod 254 of the driving motor 253. The at least one sliding rod 256 is slidably mounted through the at least one guiding tube 252. Each of the at least one sliding rod 256 has an upper end and a lower end. The upper end of the sliding rod 256 extends upward and protrudes out of the guiding tube 252. The lower end of the sliding rod 256 extends downward, protrudes out of the guiding tube 252, is mounted through the outer cap 23, and is securely attached to the inner cap 24. The moving seat 257 is securely mounted on the at least one upper end of the at least one sliding rod 256. The rack 258 is securely mounted on the moving seat 257 and engages with the pinion 255. Thus, when the driving motor 253 drives the driving rod 254 of the driving motor 253 and the pinion 255 to rotate, the rack 258, the moving seat 257, the at least one sliding rod 256, and the inner cap 24 slide upward and downward accordingly.

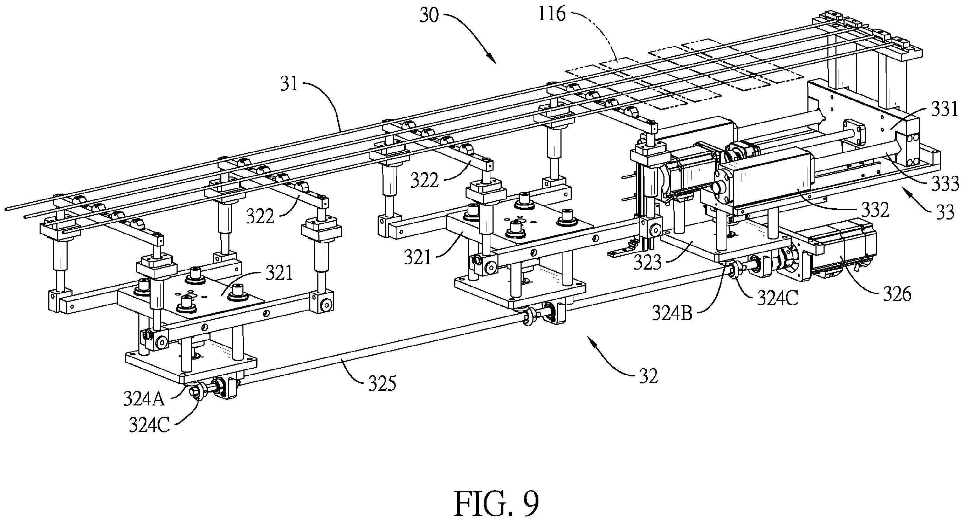

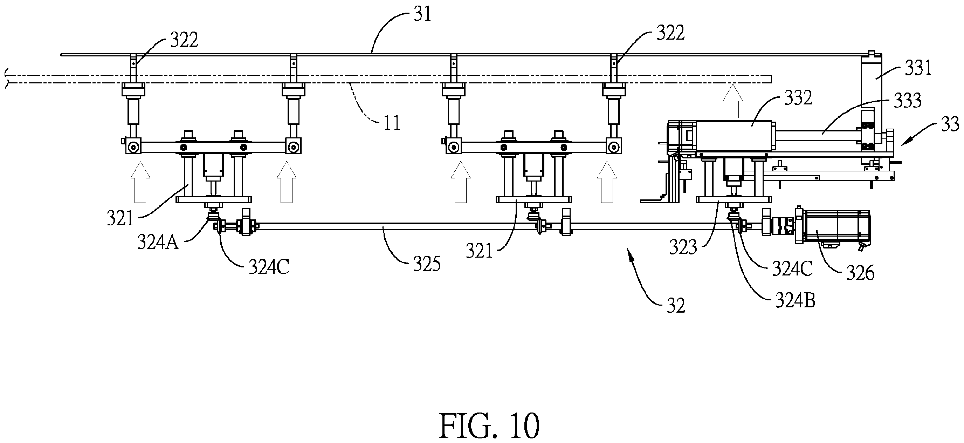

With further reference to Figs. 9 and 10, the at least one conveying device 30 is disposed on the conveying platform 11. Each of the at least one conveying device 30 includes four supporting rods 31, a Z-axis driving assembly 32, and an X-axis driving assembly 33. The four supporting rods 31 are separately mounted on the heating bases 116, 116A and are respectively mounted in the grooves 117, 117A of each of the heating bases 116, 116A. The lead frames are supported by the heating bases 116, 116A and the supporting rods 31. The Z-axis driving assembly 32 is connected to the four supporting rods 31 and selectively drives the four supporting rods 31 to move upward and downward perpendicular to the conveying platform 11. The X-axis driving assembly 33 is connected to the four supporting rods 31 and selectively drives the four supporting rods 31 to move back and forth between the input end 111 and the output end 112 of the conveying platform 11.

As shown in Fig. 10, when the conveying device 30 operates, the Z-axis driving assembly 32 of each of the at least one conveying device 30 drives the four supporting rods 31 to move upward, such that the supporting rods 31 and the lead frames are raised to depart from the heating bases 116, 116A.

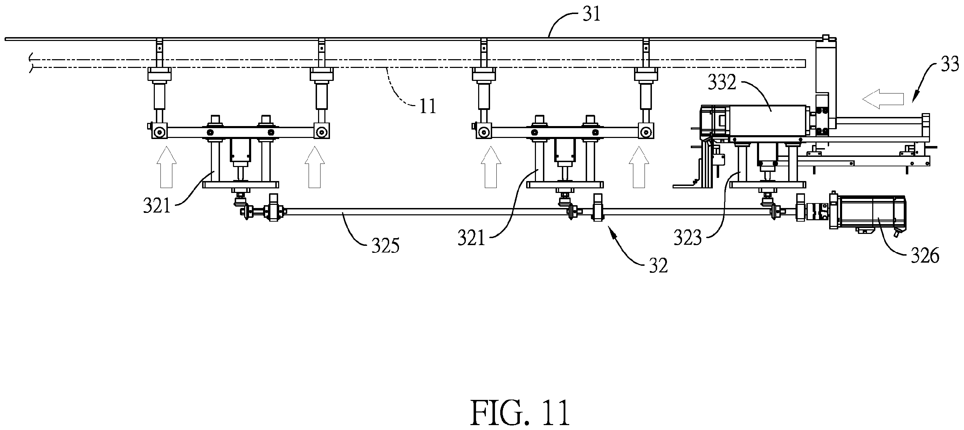

With further reference to Fig. 11, then the X-axis driving assembly 33 of each of the conveying device 30 drives the four supporting rods 31 to move toward the output end 112 of the conveying platform 11, such that each of the lead frames is moved to corresponds in position to the other heating base 116, 116A.

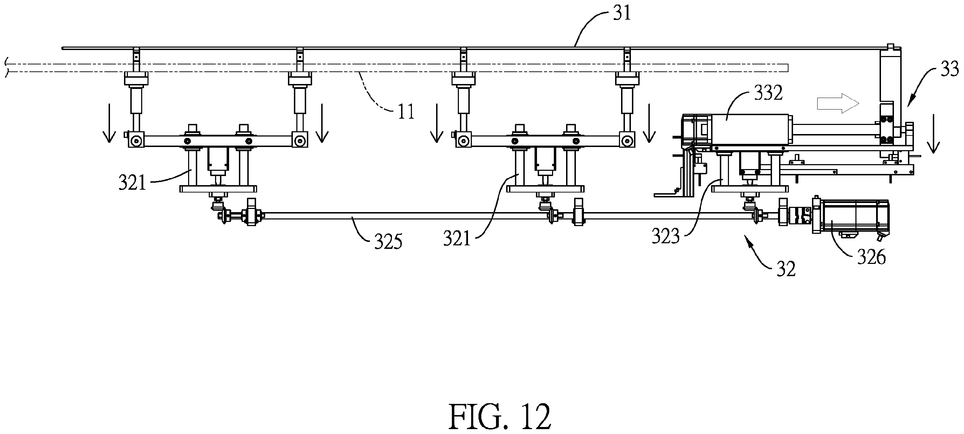

With further reference to Fig. 12, then the Z-axis driving assembly 32 of each of the at least one conveying device 30 drives the four supporting rods 31 to move downward into the grooves 117, 117A of the heating bases 116, 116A, such that each of the lead frames is placed on said the other heating base 116, 116A.

Then the X-axis driving assembly 33 drives the four supporting rods 31 to move along the grooves 117, 117A of the heating bases 116, 116A toward the input end 111 of the conveying platform 11, so as to repeat the afore-mentioned steps of moving the lead frames.

In the preferred embodiment, the Z-axis driving assembly 32 is disposed below the conveying platform 11 and has at least one first supporting seat 321, a second supporting seat 323, a transmission rod 325, and a Z-axis driving motor 326. The at least one first supporting seat 321 and the second supporting seat 323 are separately arranged along an elongation axis of the supporting rod 31. Each of the at least one first supporting seat 321 has at least one supporting bracket 322. The at least one supporting bracket 322 is disposed on a top of the first supporting seat 321. The four supporting rods 31 are mounted on and are supported by the at least one supporting bracket 322. Furthermore, each of the first and second supporting seats 321, 323 has a nut, a threaded rod, and a bevel gear 324A, 324B. The nut is securely mounted in the supporting seat 321, 323. The threaded rod is rotatably mounted through and engages with the nut and has a lower end. The lower end of the threaded rod protrudes out of the supporting seat 321, 323. The bevel gear 324A, 324B is securely mounted on the lower end of the threaded rod. The transmission rod 325 is disposed below the at least one first supporting seat 321 and the second supporting seat 323. Multiple bevel gears 324C are separately mounted securely on the transmission rod 325 and respectively engage with the bevel gear 324A, 324B of the first and second supporting seats 321, 323. The Z-axis driving motor 326 is connected to the transmission rod 325 and selectively drives the transmission rod 325 to rotate. When the transmission rod 325 is driven to rotate, the threaded rods are driven to rotate relative to the nuts via the bevel gears 324A, 324B, 324C. Accordingly, the nuts as well as the at least one first supporting seat 321 and the second supporting seat 323 move upward and downward along the threaded rods.

In the preferred embodiment, the X-axis driving assembly 33 is disposed on the second supporting seat 323 of the Z-axis driving assembly 32 and has a transmission member 331 and at least one X-axis driving device 332. The transmission member 331 is connected to the four supporting rods 31. Each of the at least one X-axis driving device 332 has a driving rod 333. The driving rod 333 of the X-axis driving device 332 is connected to the transmission member 331. When the at least one driving rod 333 of the at least one X-axis driving device 332 is driven to extend or retract, the four supporting rods 31 are driven to move back and forth between the input end 111 and the output end 112 of the conveying platform 11 via the transmission member 331.

In the preferred embodiment, the at least one conveying device 30 comprises two conveying devices 30. One of the conveying devices 30 is disposed between the input end 111 of the conveying platform 11 and the vacuum generating device 20, so as to move the lead frames between the input end 111 of the conveying platform 11 and the vacuum generating device 20 one by one to the heating base 116A that corresponds in position to the vacuum generating device 20. The other conveying device 30 is disposed between the vacuum generating device 20 and the output end 112 of the conveying platform 11, so as to move the lead frames on the heating base 116A that corresponds in position to the vacuum generating device 20 and between the vacuum generating device 20 and the output end 112 of the conveying platform 11 one by one towards the output end 112 of the conveying platform 11.

When the vacuum reflow oven operates, the cover 12 covers on the conveying platform 11 and the nitrogen supply device 13 fills the gas channel 115 of the conveying platform 11 and the space defined between the first side portion 113 and the second side portion 114 of the conveying platform 11 with the nitrogen. Then the conveying device 30 moves the lead frames from the input end 111 to the output end 112 of the conveying platform 11. When the lead frames are being moved, the heating bases 116, 116A heat the lead frames, such that solder paste on the lead frames is melted and bonds with leads of chips and the nitrogen prevents the solder paste from oxidizing under high temperature. In addition, the nitrogen that is filled in the gas channel 115 of the second side portion 114 of the conveying platform 11 blocks air outside the processing apparatus 10 to prevent the air outside the process apparatus 10 from flowing into the space defined between the first side portion 113 and the second side portion 114 of the conveying platform 11. Moreover, since the conveying device 30 includes four supporting rods 31, the lead frames can be stably moved by the conveying device 30. Thus, each of the lead frames does not have to be placed on a support tray before being moved by the conveying device 30.

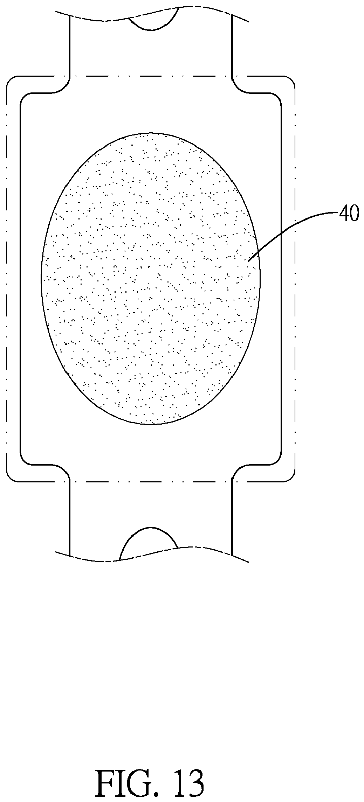

With further reference to Fig. 13, when the lead frame is placed on the heating base 116A that corresponds in position to the vacuum generating device 20, the heating base 116A continues to heat the lead frame. Meanwhile, the inner cap 24 is driven to cover on the lower seat 21 and air inside the vacuum chamber 241 is drawn out of the vacuum chamber 241 through the vacuum generating pipeline 22. Thus, gas inside the melted solder paste 40 is forced to dissipate from the solder paste 40 and voids inside the solidified solder paste 40 can be efficiently eliminated. Accordingly, joint strength between the solder paste 40 and the leads of the chips can be enhanced, electrical resistance of a solder layer that is formed from the solder paste 40 can be lowered, and quality of a soldering process is stable.

## Claims

1. A vacuum reflow oven, **characterized in that** the vacuum reflow oven comprises:
a processing apparatus (10) including
a conveying platform (11) having
an input end (111);
an output end (112), and the input end (111) and the output end (112) oppositely defined on the conveying platform (11);
a first side portion (113) defined between the input end (111) and the output end (112);
a second side portion (114) defined between the input end (111) and the output end (112), and the first side portion (113) and the second side portion (114) oppositely defined on the conveying platform (11); and
multiple heating bases (116, 116A) arranged between the input end (111) and the output end (112), each of the heating base (116, 116A) having
an upper surface; and
four grooves (117, 117A) formed separately formed in the upper surface of the heating base (116, 116A) and being parallel with each other, and each of the grooves (117, 117A) extending toward the input end (111) and the output end (112) of the conveying platform (11); and
a cover (12) selectively covering on the conveying platform (11) and having
a bottom panel (121) facing the conveying platform (11); and
a through hole (122) formed through the bottom panel (121) and corresponding in position to one of the heating bases (116, 116A) when the cover (12) covers on the conveying platform (11);
a vacuum generating device (20) mounted on the processing apparatus (10) and corresponding in position to the through hole (122) on the bottom panel (121) of the cover (12), and the vacuum generating device (20) including
a lower seat (21) mounted on the conveying platform (11) and connected with a vacuum generating pipeline (22), and the heating base (116, 116A) that corresponds in position to the through hole (122) of the bottom panel (121) mounted in the lower seat (21);
an outer cap (23) securely mounted on the bottom panel (121), corresponding in position to the through hole (122) of the bottom panel (121), and having an opening, and the opening of the outer cap (23) defined on a bottom of the outer cap (23) and facing toward and communicating with the through hole (122) of the bottom panel (121);
an inner cap (24) disposed in the outer cap (23) and having an opening defined on a bottom of the inner cap (24); and
a driving mechanism (25) including
a mounting seat (251) securely mounted on the outer cap (23);
at least one guiding tube (252) securely mounted on the outer cap (23); a driving motor (253) securely mounted on the mounting seat (251) and having a driving rod (254);
a pinion (255) securely mounted on the driving rod (254) of the driving motor (253);
at least one sliding rod (256) slidably mounted through the at least one guiding tube (252), and each of the at least one sliding rod (256) having
an upper end extending upward and protruding out of the guiding tube (252); and
a lower end extending downward, protruding out of the guiding tube (252), and securely attached to the inner cap (24);
a moving seat (257) securely mounted on the at least one upper end of the at least one sliding rod (256); and
a rack (258) securely mounted on the moving seat (257) and engaging with the pinion (255); and
wherein when the driving motor (253) drives the driving rod (254) of the driving motor (253) and the pinion (255) to rotate, the rack (258), the moving seat (257), the at least one sliding rod (256), and the inner cap (24) slide upward and downward accordingly, and when the cover (12) covers on the conveying platform (11), the driving mechanism (25) selectively drives the inner cap (24) to move downward to cover on the lower seat (21);
at least one conveying device (30) disposed on the conveying platform (11), and each of the at least one conveying device (30) including
four supporting rods (31) separately mounted on the heating bases (116, 116A) and respectively mounted in the grooves (117, 117A) of each of the heating bases (116, 116A);
a Z-axis driving assembly (32) connected to the four supporting rods (31) and selectively driving the four supporting rods (31) to move upward and downward perpendicular to the conveying platform (11); and
an X-axis driving assembly (33) connected to the four supporting rods (31) and selectively driving the four supporting rods (31) to move back and forth between the input end and the output end of the conveying platform (11).

2. The vacuum reflow oven as claimed in claim 1, wherein
the conveying platform (11) further has a gas channel (115) formed in the second side portion (114) of the conveying platform (11), extending toward the input end (111) and the output end (112) of the conveying platform (11), and communicating with a space defined between the first side portion (113) and the second side portion (114); and
the processing apparatus (10) further includes a nitrogen supply device (13) connected with the gas channel (115) of the conveying platform (11) through a nitrogen pipeline (131).

3. The vacuum reflow oven as claimed in claim 1 or 2, wherein
the Z-axis driving assembly (32) of each of the at least one conveying device (30) is disposed below the conveying platform (11) and has
at least one first supporting seat (321) and a second supporting seat (323) separately arranged along an elongation axis of the supporting rod (31), each of the at least one first supporting seat (321) having at least one supporting bracket (322) disposed on a top of the first supporting seat (321) and supporting the four supporting rods (31), and each of the first and second supporting seats (321, 323) having
a nut securely mounted in the supporting seat (321, 323);
a threaded rod rotatably mounted through and engaging with the nut and having a lower end protruding out of the supporting seat (321, 323); and
a bevel gear (324A, 324B) securely mounted on the lower end of the threaded rod;
a transmission rod (325) disposed below the at least one first supporting seat (321) and the second supporting seat (323);
multiple bevel gears (324C) separately mounted securely on the transmission rod (325) and respectively engaging with the bevel gear (324A, 324B) of the first and second supporting seats (321, 323); and
a Z-axis driving motor (326) connected to the transmission rod (325) and selectively driving the transmission rod (325) to rotate, so as to drive the at least one first supporting seat (321) and the second supporting seat (323) to move upward and downward; and
the X-axis driving assembly (33) of each of the at least one conveying device (30) disposed on the second supporting seat (323) of the Z-axis driving assembly (32) and having
a transmission member (331) connected to the four supporting rods (31); and
at least one X-axis driving device (332), and each of the at least one X-axis driving device (332) having a driving rod (333) connected to the transmission member (331);
wherein when the at least one driving rod (333) of the at least one X-axis driving device (332) is driven to extend or retract, the four supporting rods (31) are driven to move back and forth between the input end (111) and the output end (112) of the conveying platform (11) via the transmission member (331).

4. The vacuum reflow oven as claimed in claim 1, 2, or 3, wherein
the cover (12) is pivotally connected to the first side portion (113) of the conveying platform (11); and
the processing apparatus (10) further has
at least one opening mechanism (14) disposed beside the first side portion (113) of the conveying platform (11), connected to the cover (12), and selectively driving the cover (12) to pivot relative to the conveying platform (11); and
at least one holding mechanism (15) disposed beside the second side portion (114) of the conveying platform (11) and selectively pressed on the cover (12) when the cover (12) covers on the conveying platform (11).

5. The vacuum reflow oven as claimed in claim 4, wherein each of the at least one opening mechanism (14) includes
a fixed seat (141) mounted beside the first side portion (113) of the conveying platform (11);
a connecting member (142) securely mounted on the cover (12) and pivotally connected to the first side portion (113) of the conveying platform (11); and
a retractable rod (143) having two ends respectively connected to the fixed seat (141) and the connecting member (142).

6. The vacuum reflow oven as claimed in claim 4, wherein the at least one conveying device (30) comprises two conveying devices (30), one of the conveying devices (30) is disposed between the input end (111) of the conveying platform (11) and the vacuum generating device (20) and the other conveying device (30) is disposed between the vacuum generating device (20) and the output end (112) of the conveying platform (11).
